# DEMANDE DE BREVET EUROPEEN

(11) **EP 3 697 186 A1**
(43) Date de publication de la demande: **19.08.2020**
(21) Numéro de dépôt: 20157058.7
(22) Date de dépôt: 13.02.2020
(51) Int. Cl.: H05K 13/02

(54) **MACHINE DE PRÉPARATION DES BROCHES ÉLECTRIQUES DE COMPOSANTS**

(30) Priorité: 14.02.2019 FR 1901492
(71) Demandeur: MGA Technologies, 69380 Civrieux d'Azergues (FR)
(72) Inventeur: de MALLIARD, Hervé, 69160 Tassin la Demi-Lune (FR)
(74) Mandataire: Chevalier, Renaud Philippe

(57) **Abrégé**

Machine de préparation des broches électriques de composants fixées à un corps de ce composant, comportant un plateau tournant (12) suivant un axe vertical comprenant au moins quatre posages horizontaux (18) disposés sur le contour extérieur, et au moins quatre postes disposés au niveau de posages (18), comprenant successivement un poste d'arrivée (14) d'un composant sur chaque posage (18), au moins un poste de cambrage des broches (16, 20), un poste de coupe des broches (22), et un poste de départ des composants (24).

## Description

La présente invention concerne une machine de préparation des broches de contact électrique de composants.

Les composants électroniques comprenant un corps équipé de broches pour assurer les contacts électriques, sont de plus en plus utilisés. En particulier les véhicules automobiles comportent un nombre croissant de systèmes électroniques, notamment pour améliorer le contrôle de la combustion des moteurs thermiques ou pour commander des machines électriques de traction de véhicules hybrides ou électriques, afin de réduire la consommation d'énergie et les émissions de gaz polluants, pour aider à la conduite, l'automatiser, ou pour de nombreuses autres fonctions afin d'améliorer le confort et la sécurité.

En particulier les capteurs à effet hall sont utilisés dans des systèmes mécatroniques, pour mesurer ou contrôler des déplacements ou des positions.

Ces composants peuvent être produits en grande série avec des broches disposées dans un même plan, formant un standard de fabrication. Il faut ensuite suivant les applications réaliser un cambrage et une coupe spécifiques des extrémités des broches, afin d'obtenir le meilleur positionnement des broches et des points de contact sur un ensemble, permettant d'optimiser l'encombrement et la masse du système réalisé ainsi que son coût.

Il est connu de réaliser d'une part des postes de cambrage des broches, et d'autre part des postes de coupe séparés, ce qui pose des problèmes de déplacement des composants d'un poste à l'autre avec des cadences élevées, en conservant des orientations spécifiques de ces composants, sans risquer de défaillance.

De plus le procédé de production doit pouvoir s'adapter facilement à différents types de composants, ou à des cambrages et des coupes variées des broches d'un même type de composant, afin de réduire les coûts des investissements.

La présente invention a notamment pour but d'éviter ces inconvénients de la technique antérieure.

Elle propose à cet effet une machine de préparation des broches électriques de composants fixées à un corps de ce composant, remarquable en ce qu'elle comporte un plateau tournant suivant un axe vertical comprenant au moins quatre posages horizontaux disposés sur le contour extérieur, et au moins quatre postes disposés au niveau de posages, comprenant successivement un poste d'arrivée d'un composant sur chaque posage, au moins un poste de cambrage des broches, un poste de coupe des broches, et un poste de départ des composants.

Un avantage de cette machine de préparation des broches et que dans un même ensemble, le plateau rotatif permet au poste d'arrivée de recevoir, de mettre en référence et de maintenir en position chaque composant sur un posage, ce composant gardant son même positionnement précis par rapport au plateau lors des différentes rotations du plateau l'avançant à chaque fois d'un pas pour effectuer une opération à chaque poste.

On peut ainsi effectuer de manière fiable les opérations successives de cambrage puis de coupe des broches, avec un temps très court de rotation du plateau suivant un pas, avançant tous les composants sur ce plateau sans avoir besoin à chaque fois de refaire une mise en référence, ce qui permet une cadence élevée.

La machine de préparation selon l'invention peut comporter de plus une ou plusieurs des caractéristiques suivantes, qui peuvent être combinées entre elles.

Avantageusement, chaque posage comporte un appui latéral de mise en référence en direction du centre du plateau.

Dans ce cas, avantageusement chaque posage comporte une languette élastique de maintien du composant en référence.

Avantageusement, le poste d'arrivée comporte un système de déroulement d'une bande continue présentant des alvéoles contenant les composants, ou présentant des composants fixés sur cette bande par leurs broches.

Avantageusement, un poste de cambrage des broches comporte un serre-flanc serrant les broches tournées radialement vers l'extérieur du plateau, près du corps de ce composant, et des matrices réalisant le cambrage à l'extérieur du serre-flanc.

Avantageusement, le poste de coupe des broches comporte une pince mobile serrant les broches suivant une direction radiale du plateau, et une lame de coupe coulissant juste au-dessus de la pince mobile.

Avantageusement, chaque poste de cambrage et de coupe est ajusté sur une glissière fixée sur la machine suivant une direction radiale du plateau.

Dans ce cas, avantageusement chaque glissière radiale comporte des butées réglables de positionnement radial du poste de cambrage ou de coupe.

Avantageusement, la machine de préparation comporte un convoyeur de sortie comprenant une bande continue, entraînant des navettes équipées chacune d'un logement de positionnement d'un composant.

Dans ce cas, en complément chaque navette peut comporter un pignon réalisant une rotation du composant suivant un axe vertical, et une crémaillère disposée suivant l'axe de la bande, venant en appui aux extrémités du convoyeur sur des butées pour faire tourner ce pignon.

L'invention sera mieux comprise et d'autres caractéristiques et avantages apparaîtront plus clairement à la lecture de la description ci-après donnée à titre d'exemple, en référence aux dessins annexés dans lesquels :
[Fig. 1] est une vue en perspective d'une machine de préparation selon l'invention ;
[Fig. 2] est une vue de dessus de cette machine comportant un plateau tournant central ;
[Fig. 3] est une vue de détail présentant la fixation des postes sur la table de la machine ;
[Fig. 4] présente le convoyeur d'arrivée des composants ;
[Fig. 5] présente la dépose d'un composant sur un posage du plateau tournant ;
[Fig. 6] présente un premier poste de cambrage disposé après une première rotation du plateau ;
[Fig. 7] présente un deuxième poste de cambrage disposé après deux rotations suivantes du plateau ;
[Fig. 8] présente un poste de coupe disposé après une rotation suivante du plateau ;
[Fig. 9] présente la coupe des broches ;
[Fig. 10] présente un poste de départ disposé après une rotation suivante du plateau ;
[Fig. 11] présente la montée des pinces après la saisie d'un composant à ce poste de départ ;
[Fig. 12] présente un mouvement de translation de ce poste de départ pour déposer le composant sur un convoyeur de sortie ;
[Fig. 13] présente le convoyeur de sortie de cette machine ;
[Fig. 14] présente une navette de ce convoyeur ;
[Fig. 15] présente le départ du convoyeur comprenant un système de contrôle de présence du composant ;
[Fig. 16] présente le convoyeur avec une navette à l'arrivée ;
[Fig. 17] présente une vue de dessous d'une navette suivant une variante, équipée d'un système de rotation du composant ;
[Fig. 18] présente la navette à l'arrivée, vue en coupe suivant un plan vertical passant par l'axe médian d'une crémaillère de cette navette ;
[Fig. 19] présente une navette pour un convoyeur suivant une variante, comprenant des taquets d'entraînement fixés sur sa bande continue ;
[Fig. 20] présente le départ de ce convoyeur ; et
[Fig. 21] présente l'arrivée de ce convoyeur.

D'une manière générale la machine de préparation selon l'invention peut s'appliquer à tous types de composants, comprenant un corps et au moins une broche à cambrer.

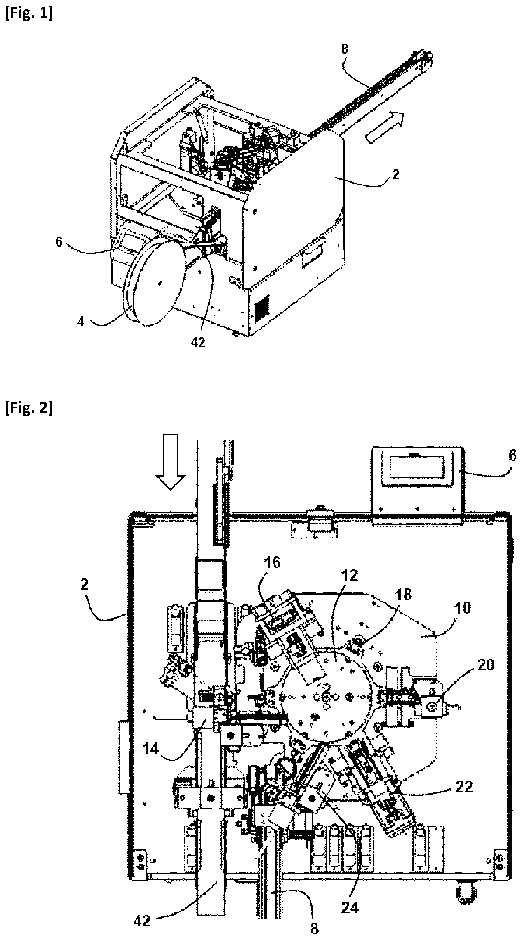

Les figures 1 et 2 présentent une machine de préparation de forme extérieure sensiblement carrée, entourée par un carter de protection 2, comprenant à l'extérieur sur une face un pupitre de contrôle 6, et une bobine 4 tournant autour d'un axe horizontal, déroulant une bande continue 42. La bande continue 42 comporte des alvéoles recevant chacune un composant électronique présentant des broches électriques alignées transversalement, qui sont à cambrer et à couper.

La machine de préparation est entièrement automatisée avec une commande par un automate qui séquence toutes les opérations successives, et effectue les contrôles nécessaires.

Le côté opposé de la machine comporte un convoyeur de sortie 8, éloignant les composants préparés pour permettre à l'extrémité de ce convoyeur une préhension par un opérateur, ou par un équipement de préhension automatisé de type robot ou bras manipulateur.

La machine comporte une table 10 supportant au milieu un plateau tournant 12 monté sur un axe vertical, équipé de six posages 18 répartis de manière régulière sur son contour suivant des angles de 60°. Par la suite les directions extérieure et intérieure sont définies radialement par rapport à l'axe du plateau tournant 12.

Chaque posage 18 forme un plan horizontal recevant le corps d'un composant, qui est calé en direction du centre du plateau 12 sur un appui latéral de mise en référence, afin de présenter une position définie. Chaque composant présente des broches parallèles disposées dans un même plan horizontal, tournées radialement vers l'extérieur. Les extrémités des broches peuvent être reliées entre elles par un surmoulage en matière plastique, afin de les maintenir en position.

Un premier posage 18 disposé suivant une direction radiale du plateau 12 perpendiculaire à l'axe de la bande continue 42, comporte un poste d'arrivée 14 déposant un composant à la fois sur le posage de ce poste.

On a ensuite au niveau des posages successifs 18, pour une rotation du plateau 12 dans le sens horaire, un premier poste de cambrage des broches 16, un emplacement qui est vide dans cet exemple, un deuxième poste de cambrage 20, un poste de coupe des broches 22, et un poste de départ des composants 24 les déposant sur le convoyeur 8. De cette manière cinq rotations successives de 60° chacune, font passer chaque composant du poste d'arrivée 14 au poste de départ 24.

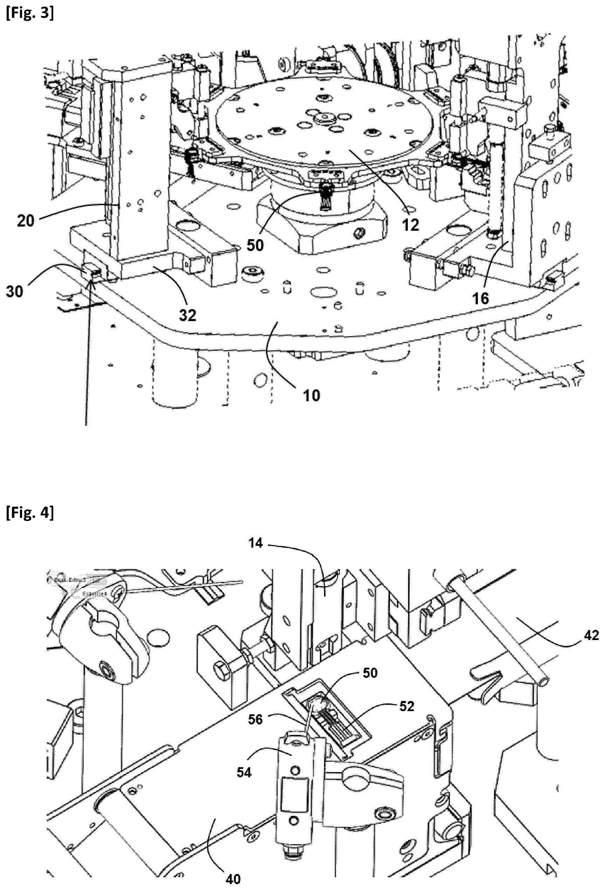

La figure 3 présente les postes de travail 16, 20 montés chacun sur un socle horizontal 32, qui est positionné sur une glissière 30 fixée sur la table 10, dans la direction radiale par rapport au centre du plateau tournant 12.

Des butées réglables permettent d'ajuster avec précision chaque poste de travail 16, 20 suivant la direction radiale, en coulissant sur la glissière 30, de manière à positionner ses outils rapidement et avec précision par rapport aux broches 52 du composant 50 tournées radialement vers l'extérieur. On peut ainsi facilement changer les postes de travail pour s'adapter à différents types de coupe et cambrage, ou à des variétés de composants.

La figure 4 présente le poste d'arrivée 14 recevant la bande continue 42, qui passe sous une plaque 40 en ajustant successivement une alvéole à l'intérieur d'une fenêtre de cette plaque, contenant le composant 50 avec ses pattes 52 disposées transversalement. Une tête de lecture laser 54 vérifie avec un rayon laser 56 la présence du composant 50 à l'intérieur de la fenêtre de la plaque 40.

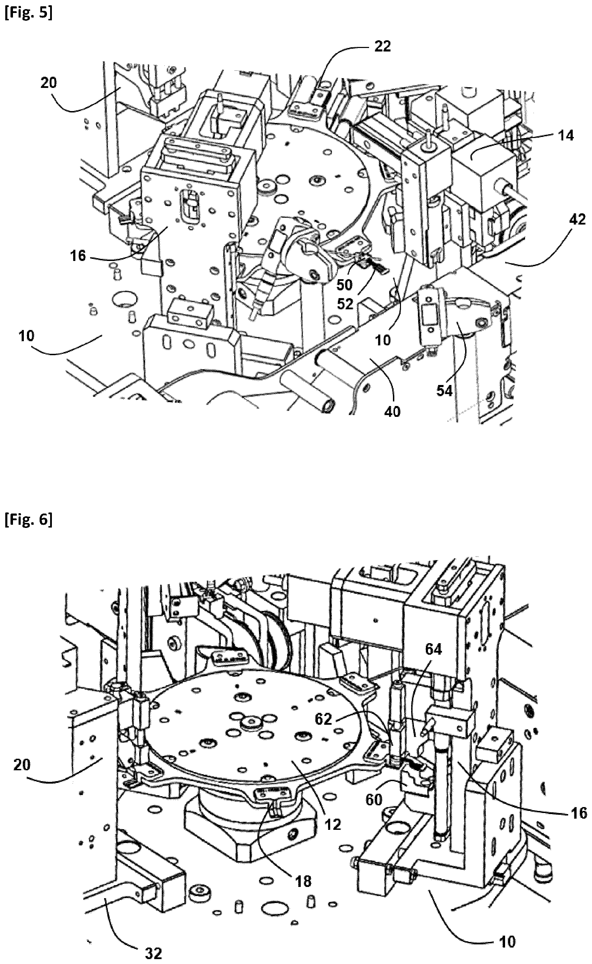

La figure 5 présente un bras robotisé du poste d'arrivée 14, qui descend un système de préhension par aimantation dans le cas d'un composant 50 magnétique, ou par pince saisissant une broche 52 dans le cas d'un composant amagnétique, pour successivement le lever suivant un axe vertical, puis le translater suivant une direction radiale, et enfin le descendre sur le posage 18 disposé à ce poste.

Avantageusement la descente du composant 50 se fait à une petite distance radiale vers l'extérieur d'un appui latéral du posage 18 disposé vers le centre du plateau 12, de manière à ne pas buter sur cet appui lors de la descente. Après cette descente le système de préhension décale légèrement vers l'intérieur le composant 50, pour le mettre en référence sur l'appui latéral du posage 18.

Une languette élastique peut maintenir le composant 50 en position en venant s'appuyer dessus, pour lui permettre de garder sa mise en référence lors des rotations successives du plateau 12, et des opérations effectuées sur ses broches 52.

La figure 6 présente le plateau 12 après une rotation de 60° mettant le composant 50 dans le premier poste de cambrage 16, comprenant trois éléments coulissants verticalement, comportant une matrice inférieure 60, un serre-flanc supérieur 62 et une matrice supérieure 64.

On a la montée de la matrice inférieure 60 ajustant un plan horizontal sous la partie intérieure des broches 52 disposée près du corps, puis la descente du serre-flanc 62 sur ce plan horizontal afin de pincer la base des broches.

On a ensuite la descente de la matrice supérieure 64, comprenant des formes s'ajustant sur celle de la matrice inférieure 60 pour pincer les broches 52 en réalisant leur cambrage. On a enfin l'ouverture des différents éléments coulissants pour libérer les broches 52. Une même came coulissant radialement, disposée en partie supérieure du poste, réalise les différents mouvements en faisant un aller et un retour.

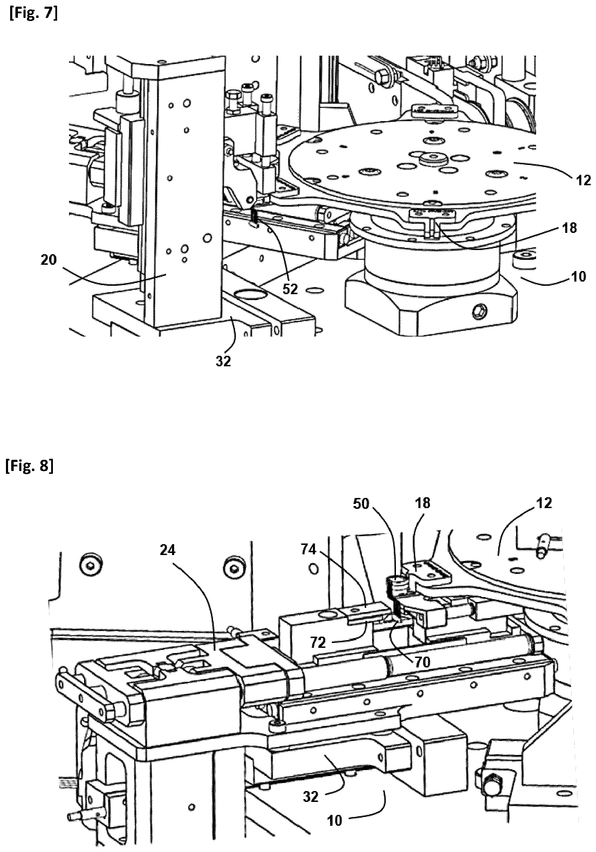

La figure 7 présente après une rotation de deux pas du plateau tournant 12, l'arrivée du composant 50 dans le deuxième poste de cambrage 20. Un galet roule sur les broches 52, afin de plier leurs extrémités en les tournant vers le bas.

La figure 8 présente après une rotation d'un pas du plateau tournant 12, l'arrivée du composant 50 dans le poste de coupe 22, la partie verticale des broches 52 arrivant tangentiellement entre des éléments mobiles radialement de ce poste.

Une même came coulissante déplace radialement les éléments mobiles, réalisant successivement un serrage au niveau de la base des broches 52 à une hauteur située juste sous le posage, par une pince mobile 72, puis l'avance d'une lame et d'une contre lame horizontales 74 formant un ciseau, coulissant juste en-dessous de cette pince, qui coupent ces broches au-dessus du surmoulage.

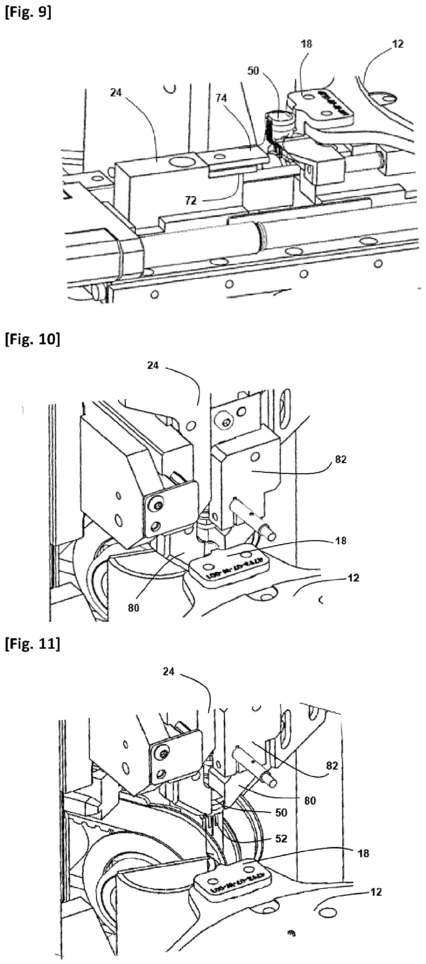

La figure 9 présente l'ouverture des éléments mobiles du poste de coupe 22, qui libèrent les broches 52 en permettant la rotation suivante du plateau tournant 12.

La figure 10 présente l'arrivée du composant 50 dans le poste de départ 24 comprenant une tête de préhension similaire à celle du poste d'arrivée 14, équipée d'un noyau en fer doux pour la prise d'un composant, ou d'une pince pour la prise du corps quand le dégagement du composant de son posage ne peut être qu'un simple mouvement vertical du fait de broches 52 repliées sous celui-ci.

En particulier la figure 10 présente une pince équipée de deux mors coulissant horizontalement 80 sous l'effet du déplacement vertical d'un axe central, qui après son ouverture est descendue autour du corps du composant 50.

La figure 11 présente après le serrage de la pince, la montée de la tête de préhension 82 qui emporte le composant 50.

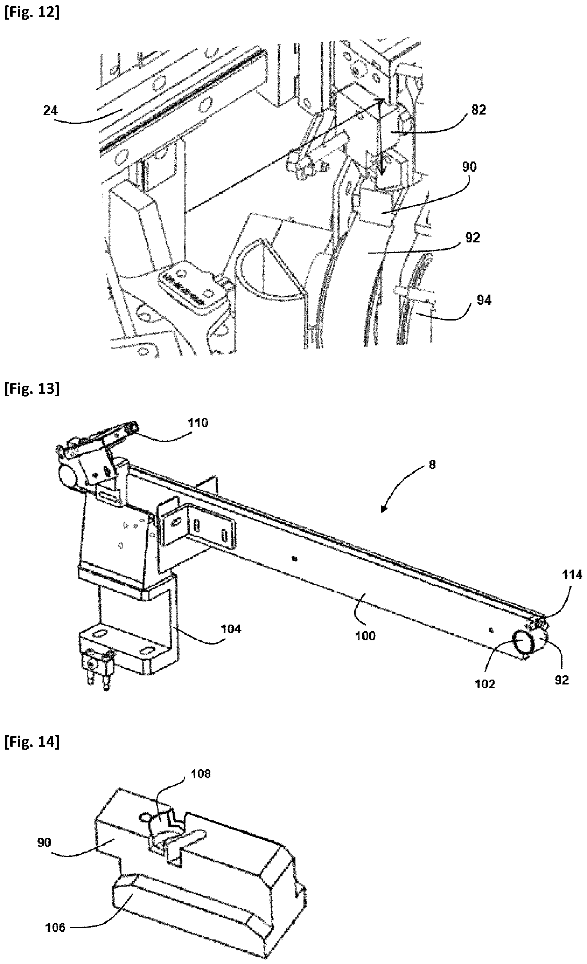

La figure 12 présente la translation horizontale du composant 50 suivant une direction radiale, puis sa descente pour le déposer sur une navette 90 posée sur une bande continue 92 du convoyeur 8, entraînée par une courroie de motorisation 94.

La figure 13 présente le convoyeur de sortie 8 comprenant la bande continue 92 faisant une boucle dans un plan vertical, présentant des dentures intérieures qui s'enroulent autour de deux cylindres 102 disposés horizontalement aux extrémités, le cylindre arrière étant motorisé pour réaliser la rotation de la bande. La bande 92 est encadrée par deux tôles de guidage latéral 100. Le convoyeur 8 est maintenu par un support 104 fixé sur la table de la machine 10.

La figure 14 présente une navette 90 comprenant une face inférieure horizontale en appui sur la bande 92 pour être entraînée par cette bande par frottement, et vers le bas de chaque côté une barrette allongée 106, comprenant aux extrémités un chanfrein supérieur facilitant l'entrée sous un repli de chaque tôle 100 pour assurer le guidage.

La navette 90 comporte sur le dessus un réceptacle 108 prévu pour recevoir de manière ajustée un composant restant orienté dans ce réceptacle, comprenant de chaque côté une fenêtre latérale.

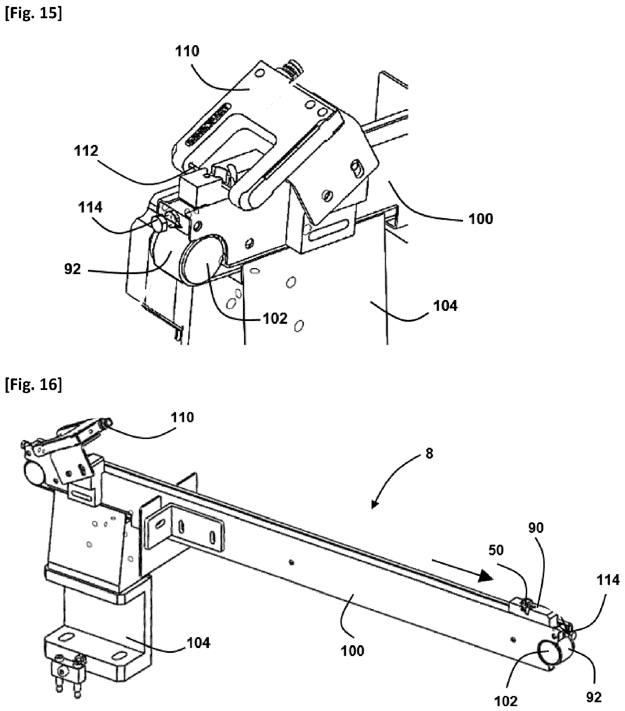

La figure 15 présente la navette 90 en appui sur une butée réglable 114 à l'arrière du convoyeur 8, après un recul de la bande 92, ne comportant pas de composant.

Une fourchette supérieure 110 fixée au support 104, envoie un rayon optique 112 traversant le réceptacle 108 par ses fenêtres latérales, qui permet de vérifier l'absence de composant. La dépose d'un composant 50 dans le réceptacle 108 par le poste de départ 24 est détecté par la coupure du rayon optique 112.

La figure 16 présente le mouvement vers l'avant de la navette 90 après la détection de la dépose du composant 50, entraîné par friction par la bande continue 92 qui a démarré vers l'avant, venant en fin de course en appui sur une butée avant réglable 114. Un opérateur, ou un équipement de préhension automatisé, peut alors saisir le composant 50 qui se trouve à une position définie.

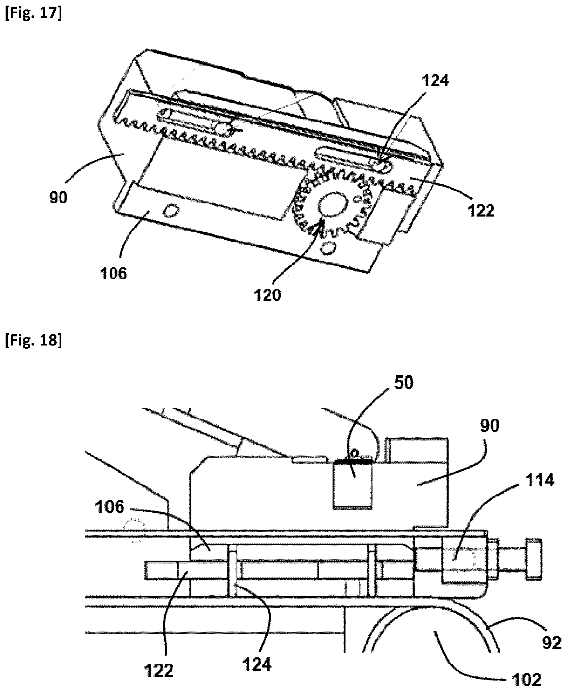

Les figures 17 et 18 présentent en variante une navette 90 comportant au fond du réceptacle 108 un support fixé sur un axe vertical, relié en dessous de cette navette à un pignon 120 qui engrène avec une crémaillère 122 disposée suivant l'axe longitudinal, guidée par deux pions 124.

Lors de l'arrivée sur la butée avant 114 présentée figure 18, cette butée appui sur la crémaillère 122 en la reculant par rapport à la navette 90, ce qui entraîne la rotation du pignon 120, et du composant 50 posé sur le support lié à ce pignon. On obtient une orientation du composant 50 suivant un angle qui peut être ajusté par la longueur de coulissement de la crémaillère 122.

A l'inverse lors du recul suivant de la navette 90, en arrivant en appui sur la buté arrière 114 la crémaillère 122 coulisse dans l'autre sens, ce qui remet le pignon 120 et son support dans la position d'origine, afin de recommencer un cycle.

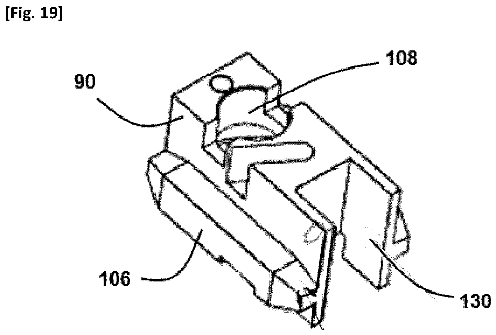

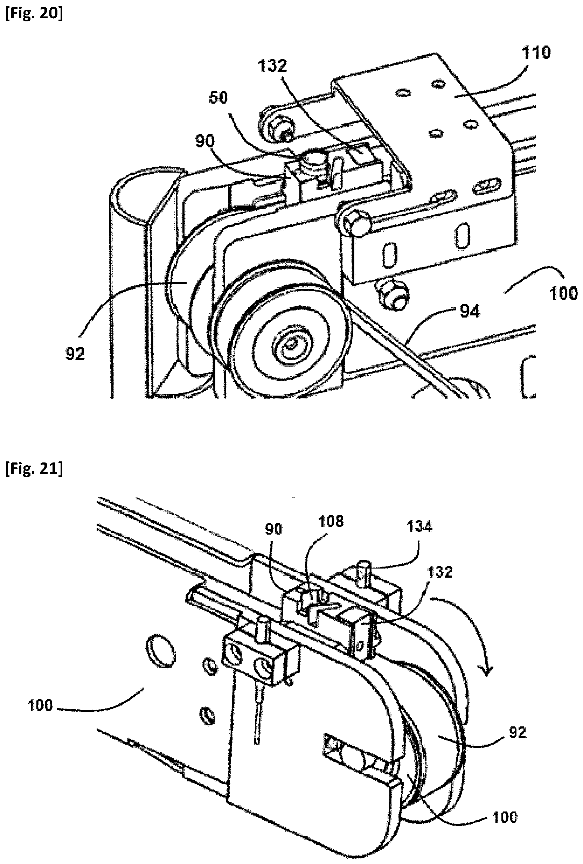

Les figures 19, 20 et 21 présentent une navette 90 comportant à l'avant une échancrure verticale 130 traversant cette navette, recevant à l'intérieur un taquet parallélépipédique 132 lié à cette navette par une vis, qui est fixé sur la bande continue 92.

La navette 90 s'arrête à l'avant du convoyeur 8 en arrivant devant des cellules optiques de détection avant 134, ce qui arrête ce convoyeur pour permettre à un opérateur de saisir le composant sur cette navette. Après le retrait du composant enregistré par les cellules avant 134, la bande continue 92 redémarre pour passer la navette 90 en dessous, puis la remettre à la position de départ afin de recevoir un nouveau composant.

## Revendications

1. Machine de préparation des broches électriques (52) de composants (50) fixées à un corps de ce composant (50), **caractérisée en ce qu'**elle comporte un plateau tournant (12) suivant un axe vertical comprenant au moins quatre posages horizontaux (18) disposés sur le contour extérieur, et au moins quatre postes disposés au niveau de posages (18), comprenant successivement un poste d'arrivée (14) d'un composant (50) sur chaque posage (18), au moins un poste de cambrage des broches (16, 20), un poste de coupe des broches (22), et un poste de départ des composants (24).

2. Machine de préparation selon la revendication 1, **caractérisée en ce que** chaque posage (18) comporte un appui latéral de mise en référence en direction du centre du plateau (12).

3. Machine de préparation selon la revendication 2, **caractérisée en ce que** chaque posage (18) comporte une languette élastique de maintien du composant (50) en référence.

4. Machine de préparation selon l'une quelconque des revendications précédentes, **caractérisée en ce que** le poste d'arrivée (14) comporte un système de déroulement d'une bande continue (42) présentant des alvéoles contenant les composants (50), ou présentant des composants (50) fixés sur cette bande (42) par leurs broches (52).

5. Machine de préparation selon l'une quelconque des revendications précédentes, **caractérisée en ce qu'**un poste de cambrage des broches (16) comporte un serre-flanc (62) serrant les broches (52) tournées radialement vers l'extérieur du plateau (12), près du corps de ce composant, et des matrices (60, 64) réalisant le cambrage à l'extérieur du serre-flanc (62).

6. Machine de préparation selon l'une quelconque des revendications précédentes, **caractérisée en ce que** le poste de coupe des broches (22) comporte une pince mobile (72) serrant les broches (52) suivant une direction radiale du plateau (12), et une lame de coupe (74) coulissant juste au-dessus de la pince mobile (70).

7. Machine de préparation selon l'une quelconque des revendications précédentes, **caractérisée en ce que** chaque poste de cambrage (16, 20) et de coupe (22) est ajusté sur une glissière (30) fixée sur la machine suivant une direction radiale du plateau (12).

8. Machine de préparation selon la revendication 7, **caractérisée en ce que** chaque glissière radiale (30) comporte des butées réglables de positionnement radial du poste de cambrage ou de coupe (16, 20, 22).

9. Machine de préparation selon l'une quelconque des revendications précédentes, **caractérisée en ce qu'**elle comporte un convoyeur de sortie (8) comprenant une bande continue (92), entraînant des navettes (90) équipées chacun d'un logement (108) de positionnement d'un composant (50).

10. Machine de préparation selon la revendication 9, **caractérisée en ce que** chaque navette (90) comporte un pignon (120) réalisant une rotation du composant (50) suivant un axe vertical, et une crémaillère (122) disposée suivant l'axe de la bande (90), venant en appui aux extrémités du convoyeur (8) sur des butées (114) pour faire tourner ce pignon (120).
